# EUROPÄISCHE PATENTSCHRIFT

(11) **EP 0 529 118 B1**
(45) Veröffentlichungstag und Bekanntmachung des Hinweises auf die Patenterteilung: **23.10.1996**
(21) Anmeldenummer: 91114120.8
(22) Anmeldetag: 23.08.1991
(51) Int. Cl.: H03K 17/04

(54) **Stromregelschaltung**
Current regulating circuit
Circuit de régulation de courant

(43) Veröffentlichungstag der Anmeldung: 03.03.1993
(73) Patentinhaber: Deutsche ITT Industries GmbH, 79108 Freiburg (DE)
(72) Erfinder: Theus, Ulrich, Dr.-Ing., W-7803 Gundelfingen (DE); Uhlenhoff, Arnold, Dipl.-Ing., W-7830 Emmendingen (DE)

(56) Entgegenhaltungen:
- EP-A- 0 304 951
- EP-A- 0 523 266
- AT-A- 374 321
- DE-A- 3 405 936
- DE-A- 3 611 548
- DE-A- 3 910 803
- ELECTRONICS INTERNATIONAL Bd. 55, Nr. 7, April 1982, NEW YORK USA Seiten 136 - 137; SALADIN ET AL: 'PARALLEL POWER MOS FET'S INCREASE CIRCUIT CURRENT CAPACITY'

## Beschreibung

### Stromregelschaltung

Die Erfindung betrifft eine Stromregelschaltung mit einem Hauptstrompfad, der eine erste Steuerstrecke enthält, mit einem Referenzstrompfad, der eine gleichartige zweite Steuerstrecke enthält, und mit einer Steuereinrichtung, die der parallelen Steuerung der ersten und der ersten Steuerstrecke dient, wobei
- der Hauptstrompfad zwischen einem Versorgungsanschluß und dem Stromeingang der ersten Steuerstrecke eine Last enthält, deren Strom zu regeln ist,
- der Referenzstrompfad eine Stromquelle enthält, deren Ausgang mit dem Stromeingang der zweiten Steuerstrecke gekoppelt ist,
- die Steuereinrichtung als Regelverstärker einen Differenzverstärker enthält, dessen invertierender bzw. nichtinvertierender Eingang mit der Stromklemme der ersten bzw. zweiten Steuerstrecke gekoppelt ist, und
- die erste und zweite Steuerstrecke monolithisch integriert sind, vgl. den Wortlaut des Oberbegriffes von Anspruch 1.

Eine derartige Stromregelschaltung für hochgenaue Stromspiegelschaltungen ist in DE-A 36 11 548 beschrieben. Zwar wird dort nicht auf eine monolithisch integrierte Schaltung hingewiesen, jedoch wird erwähnt, daß die beiden Stromspiegeltransistoren, die den obengenannten beiden Steuerstrecken entsprechen, unter ähnlichen Bedingungen betrieben werden können, so daß eine nahezu ideale Stromspiegelung vorliege. Die in DE-A 36 11 548 beschriebenen Stromspiegelschaltungen dienen der exakten, statischen Stromspiegelung ohne Stromübersetzung.

In der nichtvorveröffentlichten EP-A 0 523 266 wird ein integrierbarer Stromspiegel beschrieben, der neben weiteren Schaltungsteilen die gleichen Grundschaltungen wie in DE-A 36 11 548 enthält. Die Beschreibung weist darauf hin, daß mittels einer Geometrievorgabe der Stromspiegeltransistoren eine beliebige Stromübersetzung vorgebbar sei. Ferner wird durch zusätzliche Schaltungstransistoren erreicht, daß der Stromspiegel über einen Steuereingang mit einem digitalen Signal angesteuert werden kann, um einen impulsförmigen, geregelten Ausgangsstrom zu erzeugen.

Ein Anwendungsbereich für eine derartige Stromregelschaltung mit Tastung des Ausgangsstromes ist beispielsweise ein Fernbedienungsgeber mit einer Infrarotdiode als Sendeausgang. Da diese Fernbedienungsgeber in der Regel batteriebetrieben sind, ist die Sendeleistung der Infrarot-Ausgangsstufe ohne Regelschaltung stark vom jeweiligen Batteriezustand abhängig. Eine gleichbleibende und damit batterieschonende Sendeleistung wird durch eine Stromregelschaltung ermöglicht. Übliche Stromregelschaltungen haben jedoch meist den Nachteil, daß ein erheblicher Teil der Versorgungsspannung über der Regelstrecke durch Fühlereinrichtungen für den jeweiligen Strom verloren geht. Dies vermindert die Batterieausnutzung oder reduziert frühzeitig die Sendeleistung bei zurückgehender Batteriespannung.

Es ist daher Aufgabe, der im Anspruch 1 gekennzeichneten Erfindung, eine statische Stromregelschaltung der vorbeschriebenen Art für einen impulsgesteuerten Betrieb mit geregelter Stromamplitude weiterzubilden, wobei die Ein- und Ausschaltflanken der Stromimpulse möglichst steil sein sollen, damit zwecks Stromersparnis und zwecks geringer Verlustleistung die einzelnen Impulse schmal gehalten werden können, wodurch zusätzlich eine hohe Übertragungsfrequenz erreicht werden kann. Daneben soll durch eine hohe Stromübersetzung ein hoher Laststrom bei einem geringen Eigen- und Ruhestrombedarf ermöglicht werden.

Die Erfindung und weitere Vorteile werden nun anhand der Figuren der Zeichnung näher erläutert:
Fig. 1 zeigt schematisch als Blockschaltbild die Stromregelschaltung mit Einrichtungen zur Impulssteuerung und
Fig. 2 zeigt als Schaltung ein bevorzugtes Ausführungsbeispiel der Stromregelschaltung in CMOS-Technik.

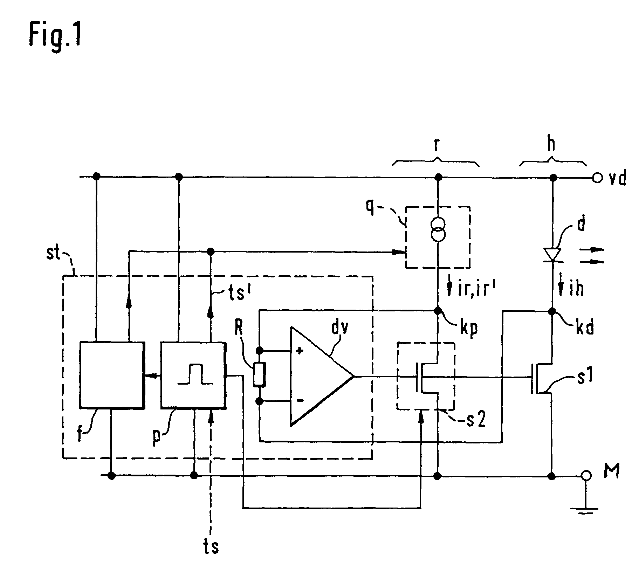

Fig. 1 zeigt schematisch im Blockschaltbild der Stromregelschaltung einen Hauptstrompfad h, einen dazu parallelen Referenzstrompfad r und eine Steuereinrichtung st. Die Steuereinrichtung enthält als Regelverstärker einen Differenzverstärker dv, der eine erste und eine zweite Steuerstrecke s1, s2 gemeinsam ansteuert, die dem Haupt- bzw. Referenzstrompfad h, r zugeordnet ist. Der Hauptstrompfad enthält in Serienschaltung zwischen einem Versorgungsanschluß vd und einem Masseanschluß M eine niederohmige Last und die erste Steuerstrecke s1. Als niederohmige Last dient in Fig. 1 eine Infrarot-Sendediode d. Als Last sind selbstverständlich beliebige Stromverbraucher oder stromgesteuerte Elemente, wie beispielsweise Hitzdraht-Sensoren, Kreuzspul-Instrumente und andere, anschließbar.

Parallel mit der ersten Steuerstrecke s1 wird die zweite Steuerstrecke s2 vom Ausgang des Differenzverstärkers dv angesteuert. Dabei wird der Stromeingang kp der zweiten Steuerstrecke von einer Stromquelle q mit einem Referenzstrom ir gespeist.

Für die Erfindung wird der Effekt ausgenutzt, daß bei gleichen Steuerstrecken, die an den Steuereingängen gleich angesteuert sind und die an den Stromeingängen die gleiche Spannung aufweisen, auch die durch die Steuerstrecken fließenden Ströme gleich sein müssen. Dieser Gleichheitszustand gilt mit einer Abänderung auch für unterschiedliche, jedoch gleichartige Steuerstrecken - die Ströme verhalten sich dann zueinander wie die zugehörigen Wirkungsgrößen der Steuerstrecken.

Die Wirkungsgröße ist von der Realisierung der Steuerstrecke abhängig und sollte möglichst rein spannungs- oder stromgesteuert sein. Die Wirkungsgröße bei der Spannungssteuerung wird im Folgenden mit "Steilheit" angegeben, womit hier der Zusammenhang zwischen dem Steuerstreckenstrom und der Steuerspannung bezeichnet wird - eine Einschränkung auf das Kleinsignalverhalten soll der Begriff nicht enthalten. Die Wirkungsgröße bei der Stromsteuerung wird im Folgenden mit "Stromverstärkung" angegeben, womit hier ein definiertes Stromübersetzungsverhältnis zwischen dem Steuerstreckenstrom und Steuerstrom gemeint ist - eine Einschränkung auf das Kleinsignalverhalten soll dieser Begriff nicht enthalten.

Werden als Steuerstrecken Feldeffekttransistoren verwendet, dann wird die jeweilige Steilheit über das W/L-Verhältnis bestimmt. Da aus Gründen einer möglichst genauen Gleichartigkeit - im Sinne einer streng proportionalen Wirkungsgröße - der ersten und zweiten Steuerstrecke die Kanallänge L gleich bleiben soll, ergibt sich aus dem Verhältnis der Kanalweiten W1 : W2 das Verhältnis der Steilheiten. Dem entspricht bei einer einfachen Ausführung in Bipolartechnik das Verhältnis, das aus den jeweils wirksamen Basis-Emitter-Flächen gebildet wird. Bei rein stromgesteuerten Steuerstrecken, beispielsweise in der Art von Stromspiegelschaltungen mit festgelegten Stromübersetzungsverhältnissen, ist der jeweilige Stromverstärkungsfaktor an den Hauptstrom ih und den Referenzstrom ir anzupassen.

Mittels des Differenzverstärkers dv wird die Spannungsdifferenz zwischen dem Stromeingang kd, kp der ersten und zweiten Steuerstrecke s1, s2 abgefühlt und die beiden Steuerstrecken gemeinsam so lange nachgesteuert, bis die Differenzspannung zu Null wird. Die Regelrichtung hängt selbstverständlich von der Regelrichtung der beiden Steuerstrecken ab, wobei zu beachten ist, daß die Verstärkung der negativen Rückkopplungsschleife größer sein muß als die Verstärkung der Mitkopplungsschleife. Dies ist in Fig. 1 erfüllt, da die Gegenkopplungsschleife über den Referenzstrompfad r durch den hohen Innenwiderstand der Stromquelle q eine höhere Verstärkung aufweist, als die Mitkopplungsschleife über den Hauptstrompfad h mit der niederohmigen Last d.

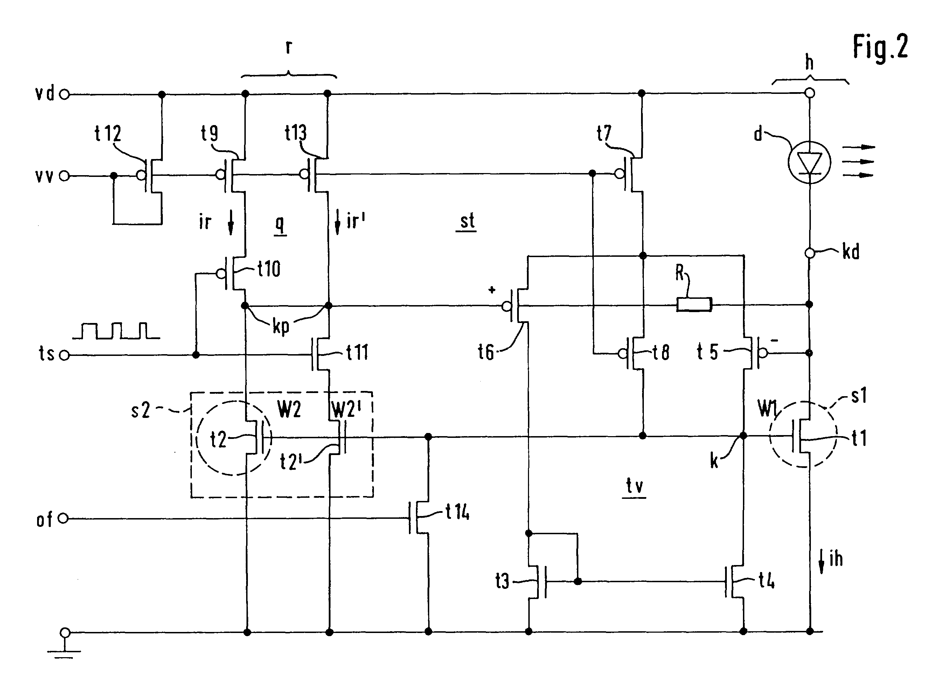

In Fig. 1 sind innerhalb der Steuereinrichtung st eine Impulsschaltstufe p und eine Vorladeeinrichtung f schematisch dargestellt. Die Impulsschaltstufe erzeugt mittels eines extern zugeführten Impuls-Steuersignals ts oder eines internen Impulsgebers Steuersignale ts', die die Stromquelle q ein- und ausschalten können - damit wird auch der Hauptstrom ih ein- und ausgeschaltet. Im Fall eines Fernbedienungsgebers mit einer Infrarot-Sendediode d liegt der Hauptstrom ih in der Größenordnung von 1 Ampere. Dies erfordert im Falle von Feldeffekt-Transistoren einen sehr großen Transistor als erste Steuerstrecke s1. Die Eingangskapazität dieses Transistors verlangsamt das Regelverhalten beim Impulsbetrieb, so daß die An- und Abstiegsflanken relativ flach verlaufen und zusätzlich gegen die Steuersignale der Impulsschaltstufe verzögert sind. Diese ständige Umladung der Steuerstrecken-Kapazität wird durch die Vorladeeinrichtung f erheblich reduziert. Durch sie bleibt die erste Steuerstrecke s1 während der Impulspause in einem Vorladezustand, der die erste Steuerstrecke für einen kleinen Vorladestrom offen hält. Dies wird durch zwei sich ergänzende Maßnahmen bewirkt. Erstens wird die Stromquelle q nicht vollständig abgeschaltet, sondern auf einen kleinen Vorlade-Referenzstrom ir' umgeschaltet. Zweitens wird zur zweiten Steuerstrecke s2 eine Hilfssteuerstrecke (siehe Fig. 2) parallelgeschaltet, welche die Steilheit oder den Stromverstärkungsfaktor der zweiten Steuerstrecke s2, beispielsweise um den Faktor 5, erhöht. Entsprechend der Größe des Vorlade-Referenzstroms ir' und dem neuen Wirkungsgrößenverhältnis zwischen der ersten und zweiten Steuerstrecke stellt sich über die Regelschaltung der gewünschte Vorladestrom im Hauptstrompfad h ein.

Der Widerstand R zwischen dem invertierenden und nichtinvertierenden Eingang des Differenzverstärkers dv dient der Stabilisierung, indem er auf einfachste Weise die Schleifenverstärkung herabsetzt.

Fig. 2 zeigt die Schaltung eines bevorzugten Ausführungsbeispiels der Stromregelschaltung in CMOS-Technik. Die erste und zweite Steuerstrecke s1, s2 bestehen aus einem ersten bzw. zweiten n-Kanal-Transistor t1, t2 mit einem W/L-Verhältnis von beispielsweise 180.000/1,5 bzw. 160/1,5. Die Hilfssteuerstrecke, die aus einem n-Kanal-Transistor t2' gebildet ist, weist ein W/L-Verhältnis von 1000/1,5 auf. Die Gate-Anschlüsse dieser drei Transistoren t1, t2, t2' liegen gemeinsam an einer Ausgangsklemme k eines Transkonduktanzverstärkers tv, der aus den n-Kanal-Transistoren t3, t4 und den p-Kanal-Transistoren t5, t6 gebildet ist und als Differenzverstärker dv dient. Der Gate-Anschluß des p-Kanal-Transistors t5 bildet den invertierenden Eingang, der mit der Anschlußklemme kd für die Last im Hauptstrompfad h verbunden ist. An der Anschlußklemme kd liegt auch der Drain-Anschluß des n-Kanal-Transistors t1.

Der Gate-Anschluß des p-Kanal-Transistors t6 ist der nichtinvertierende Eingang des Transkonduktanzverstärkers tv, der am Stromeingang kp der zweiten Steuerstrecke s2 liegt. Die Stromquelle q, die zwischen dem Versorgungsanschluß vd und dem Stromeingang kp der zweiten Steuerstrecke s2 liegt, erzeugt mittels eines p-Kanal-Transistors t9 einen Referenzstrom ir von beispielsweise 850 Mikroampere und mittels eines weiteren p-Kanal-Transistors t3 einen Vorlade-Referenzstrom ir' von beispielsweise 70 Mikroampere. Der Drain-Strom des Transistors t9 ist über einen p-Kanal-Transistor als Stromschalter t10 geführt, dessen Gate-Anschluß von dem Impuls-Steuersignal ts gesteuert ist, so daß der Referenzstrom ir vor dem Stromeingang kp der zweiten Steuerstrecke abgeschaltet werden kann.

Die zusammengeschalteten Drain-Anschlüsse der Transistoren t10, t13 sind mit dem nichtinvertierenden Eingang des Transkonduktanzverstärkers tv, mit dem Drain-Anschluß des Transistors t2 und mit dem Drain-Anschluß eines n-Kanal-Transistors t11 verbunden, dessen Gate-Anschluß vom Impuls-Steuersignal ts gespeist ist. Die Transistoren t10, t11 werden im Gegensinn durch das Impuls-Steuersignal ts geschaltet. Der Source-Anschluß des n-Kanal-Transistors t11 ist mit dem Drain-Anschluß des n-Kanal-Transistors t2' verbunden, der als Hilfssteuerstrecke dient.

Wenn der Referenzstrom ir abgeschaltet wird, dann wird der Vorlade-Referenzstrom ir' über den Schaltungsknoten kp direkt bzw. über den durchgeschalteten Transistor t11 dem Transistor t2 bzw. t2' zugeführt. Die Aufteilung erfolgt etwa im Verhältnis W2 : W2'. Für die Steilheit der zweiten Steuerstrecke s2 ist jedoch die Summe aus W1/L und W2/L einzusetzen, im Beispiel also 1160/1,5. Mit einem Vorlade-Referenzstrom ir' von 70 Mikroampere ergibt das im Hauptstrompfad einen Vorladestrom von etwa 10 Milliampere. Damit wird im Impulsbetrieb der Hauptstrom ih zwischen den Werten 1 Ampere und 10 Milliampere umgeschaltet. Die Vorladung ist dabei ausreichend hoch, ohne die Batterie während den Impulspausen wesentlich zu belasten. Hier soll nochmals auf die erreichte Realisierung möglichst kurzer Impulse mit ca. 1 Mikrosekunden Dauer hingewiesen werden.

Aus dem dargestellten Ausführungsbeispiel nach Fig. 2 ergibt sich, daß der Referenzstrompfad r während der Impulsabgabe die Summe der Drainströme von Transistor t9 und t13 der zweiten Steuerstrecke s2 zuführt. Dies läßt sich jedoch leicht in das Stromübersetzungsverhältnis von Referenzstrompfad zu Hauptstrompfad einrechnen. Mittels eines n-Kanal-Schalters, der vom Impuls-Steuersignal ts zu steuern wäre, ließe sich andererseits der Vorlade-Referenzstrom ir' während der Impulsabgabe vom Schaltungsknoten kp fernhalten.

Die Stromversorgung des Transkonduktanzverstärkers tv und der Stromquelle q erfolgt durch eine p-Kanal-Strombank, deren gemeinsames Gate-Potential an einem Vorspannungsanschluß vv liegt. Der gemeinsame Source-Anschluß der p-Kanal-Transistoren t5, t6 ist von einem p-Kanal-Transistor t7 der p-Kanal-Strombank gespeist, an dem in einer Art Kaskodeschaltung ein weiterer p-Kanal-Transistor t8 angeschlossen ist, dessen Drain-Elektrode die Ausgangsklemme k mit einem stationären Vorladestrom speist. Das gemeinsame Gate-Potential der p-Kanal-Strombank und damit das Potential der Vorspannung vv wird durch einen p-Kanal-Transistor t12 bestimmt, dessen Gate-Drain-Anschluß an der gemeinsamen Gate-Verbindungsleitung und dessen Source-Anschluß am Versorgungsanschluß vd liegt. Die am Vorspannungsanschluß vv liegende Stromquelle ist in Fig. 2 nicht dargestellt.

Die gesamte Impulssteuerung mit Vorladung wird durch ein Ausschaltsignal of unwirksam geschaltet, indem die Ausgangsklemme k durch einen n-Kanal-Transistor t14 auf Masse geschaltet wird, wenn das Ausschaltsignal of auf dem oberen Schaltpegel liegt. Durch den Transistor t14 wird auch der Steuerstrecken-Transistor t1 völlig abgeschaltet, so daß allenfalls ein Leckstrom über die Diode d fließen kann.

Die Stabilisierung des Regelkreises mit dem Transkonduktanz-Verstärker tv erfolgt wie in Fig. 1 durch einen ohmschen Widerstand R, der zwischen den invertierenden und nicht invertierenden Eingang des Transkonduktanz-Verstärkers geschaltet wird und beispielsweise 3 Kiloohm aufweist.

## Patentansprüche

1. Stromregelschaltung mit einem Hauptstrompfad (h), der eine erste Steuerstrecke (s1) enthält, mit einem Referenzstrompfad (r), der eine gleichartige zweite Steuerstrecke enthält (s2), und mit einer Steuereinrichtung (st), die der parallelen Steuerung der ersten und zweiten Steuerstrecke dient, wobei
- der Hauptstrompfad (h) zwischen einem Versorgungsanschluß (vd) und einem Eingang (kd) der ersten Steuerstrecke eine Last (d) enthält, deren Strom als Hauptstrom (ih) zu regeln ist,
- der Referenzstrompfad (r) enthält eine Stromquelle (q), die den Eingang (kp) der zweiten Steuerstrecke mit einem Referenzstrom (ir) speist,
- die Steuereinrichtung (st) als Regelverstärker einen Differenzverstärker (dv; tv) enthält, dessen invertierender bzw. nichtinvertierender Eingang mit dem Eingang (kd, kp) der ersten bzw. zweiten Steuerstrecke gekoppelt ist, und
- die erste und zweite Steuerstrecke (s1, s2) monolithisch integriert sind,
gekennzeichnet durch folgende Merkmale:
- die Steilheit bzw. Stromverstärkung der ersten Steuerstrecke (s1) weist zur Steilheit bzw. Stromverstärkung der zweiten Steuerstrecke (s2) das gleiche Verhältnis auf wie der Hauptstrom (ih) zum Referenzstrom (ir),
- die Steuereinrichtung (st) enthält ferner eine Impulsschaltstufe (p), die zur Impulssteuerung des Hauptstromes (ih) dient, wobei im impulsbetrieb die Stromamplitude durch den Regelverstärker (dv; tv) konstant gehalten ist, und
- die Impulsschaltstufe (p) aktiviert ferner während der Impulspause eine Vorladeeinrichtung (f), die mit einem Steuereingang der ersten Steuerstrecke (s1) gekoppelt ist, um im Hauptstrompfad (h) während der besagten Impulspause einen Vorladestrom einzustellen, der klein gegenüber dem impulsförmigen Hauptstrom (ih) ist.

2. Stromregelschaltung nach Anspruch 1, dadurch gekennzeichnet, daß ein Widerstand (R) zwischen dem invertierenden und nichtinvertierenden Eingang des Differenzverstärkers (dv; tv) liegt, der die Schleifenverstärkung der Stromregelschaltung herabsetzt.

3. Stromregelschaltung nach Anspruch 1 oder 2, gekennzeichnet durch folgende Merkmale:
- die Impulsschaltstufe (p) schaltet während der Impulspause die Steilheit oder die Stromverstärkung der zweiten Steuerstrecke (s2) von einem ersten Wert auf einen zweiten Wert um, der höher als der erste Wert während der Impulszeit ist und
- die von der Impulsschaltstufe gesteuerte Stromquelle (q) speist während der Impulspause die zweite Steuerstufe mit einem Vorlade-Referenzstrom (ir'), dessen Wert kleiner als der Referenzstrom (ir) ist.

4. Stromregelschaltung nach Anspruch 3, dadurch gekennzeichnet, daß die Umschaltung der Steilheit oder der Stromverstärkung durch die Parallelschaltung einer Hilfssteuerstrecke (t2') zur zweiten Steuerstrecke (s2) erfolgt.

5. Stromregelschaltung nach einem der Ansprüche 1 bis 4, dadurch gekennzeichnet, daß mindestens ein Teil der Stromregelschaltung in Feldeffekt-Transistortechnik, insbesondere in CMOS-Technik, monolithisch integriert ist.

6. Stromregelschaltung nach einem der Ansprüche 1 bis 5, dadurch gekennzeichnet, daß die Last eine Infrarot-Sendediode (d) ist.

7. Stromregelschaltung nach einem der Ansprüche 1 bis 6, dadurch gekennzeichnet, daß die Vorladeeinrichtung (f) durch ein Ausschaltsignal (of) unwirksam Schaltbar ist.

8. Stromregelschaltung nach einem der Ansprüche 5 bis 7, dadurch gekennzeichnet, daß der Differenzverstärker (dv) ein Transkonduktanzverstärker (tv) ist, dessen Ausgangsklemme (k) mit dem Gate-Anschluß eines ersten und eines zweiten Feldeffekttransistors (t1, t2), insbesondere eines ersten bzw. eines zweiten n-Kanal-Transistors, verbunden ist, der als erste bzw. zweite Steuerstrecke (s1, s2) dient.

## Claims

1. A current-regulating circuit with a main current path (h), which includes a first control path (s1), with a reference-current path (r), which includes a like, second control path (s2), and with a controller (st) for controlling the first and second control paths in parallel, wherein
- the main current path (h) includes, between a first supply terminal (vd) and an input (kd) of the first control path, a load (d) whose current is to be regulated as a main current (ih);
- the reference-current path (r) includes a current source (q) which supplies the input (kp) of the second control path with a reference current (ir);
- the controller (st) includes a regulating amplifier in the form of a differential amplifier (dv, tv) whose inverting and noninverting inputs are coupled to the inputs (kd, kp) of the first and second control paths, respectively; and
- the first and second control paths (sl, s2) are implemented using monolithic integrated circuit technology,
characterized by the following features:
- The ratio of the transconductance or current gain of the first control path (sl) to the transconductance or current gain of the second control path (s2) is the same as that of the main current (ih) to the reference current (ir);
- the controller (st) includes a pulse switching stage (p) which serves to pulse the main current (ih), the current amplitude being maintained constant by the regulating amplifier (dv; tv) during pulsed operation; and
- during the interpulse period, the pulse switching stage (p) activates a precharging device (f) which is coupled to a control input of the first control path (s1) for setting in the main current path (h), during said interpulse period, a precharging current which is small compared to the pulsed main current (ih).

2. A current-regulating circuit as claimed in claim 1, characterized in that a resistor (R) is connected between the inverting and noninverting inputs of the differential amplifier (dv; tv) for reducing the loop gain of the current-regulating circuit.

3. A current-regulating circuit as claimd in claim 1 or 2, characterized by the following features:
- During the interpulse period, the pulse switching stage (p) switches the transconductance or the current gain of the second control path (s2) from a first value to a second value which is greater than the first value during the pulse duration time; and
- during the interpulse period, the current source (q), which is controlled by the pulse switching stage, supplies the second control path with a precharge reference current (ir') whose value is less than that of the reference current (ir).

4. A current-regulating circuit as claimed in claim 3, characterized in that the switching of the transconductance or the current gain is effected by connecting an auxiliary control path (t2') in parallel with the second control path (s2).

5. A current-regulating circuit as claimed in any one of claims 1 to 4, characterized in that at least part of the current-regulating circuit is implemented using field-effect transistor technology, particularly CMOS technology.

6. A current-regulating circuit as claimed in any one of claims 1 to 5, characterized in that the load is an infrared-emitting diode (d).

7. A current-regulating circuit as claimed in any one of claims 1 to 6, characterized in that the precharging device (f) is deactivatable by a turn-off signal (of).

8. A current-regulating circuit as claimed in any one of claims 5 to 7, characterized in that the differential amplifier (dv) is a transconductance amplifier (tv) having its output terminal (k) connected to the gate terminals of a first field-effect transistor (t1) and a second field-effect transistor (t2), particularly a first n-channel transistor and a second n-channel transistor, which serve as the first and second control paths (s1, s2), respectively.

## Revendications

1. Circuit de régulation de courant comportant une voie de courant principal (h), qui contient une première section de commande (s), une voie de courant de référence (r), qui contient une seconde section identique de commande (s2), et un dispositif de commande (st), qui sert à réaliser la commande en parallèle des première et seconde sections de commande, et dans lequel
- la voie de courant principal (h) contient, entre une borne d'alimentation (vd) et une entrée (kd) de la première section de commande, une charge (d), dont le courant doit être réglé en tant que courant principal (ih),
- la voie de courant de référence (r) contient une source de courant (q), qui alimente l'entrée (kp) de la seconde section de commande avec un courant de référence (ir),
- le dispositif de commande (st) en tant qu'amplificateur de régulation contient en tant qu'amplificateur de régulation un amplificateur différentiel (dv;tv), dont l'entrée inverseuse ou non inverseuse est couplée à l'entrée (kd,dp) de la première ou de la seconde section de commande, et
- les première et seconde sections de commande (sl,s2) sont intégrées de façon monolithique,
caractérisé par les caractéristiques suivantes :
- le rapport de la pente ou l'amplification de courant de la première section de commande (s1) à la pente ou l'amplification de courant de la seconde section de commande (s2) est égal au rapport du courant principal (ih) au courant de référence (ir),
- le dispositif de commande (st) contient en outre un étage de commutation d'impulsions (p), qui sert à réaliser la commande impulsionnelle du courant principal (ih), l'amplitude du courant étant maintenue constante, pendant le fonctionnement impulsionnel, par l'amplificateur de régulation (dv;tv), et
- l'étage de commutation d'impulsions (p) active en outre, pendant la pause entre impulsions, un dispositif de précharge (f), qui est couplé à une entrée de commande de la première section de commande (s1), de manière à régler, pendant ladite pause entre impulsions, un courant de précharge qui est faible par rapport au courant principal de forme impulsionnelle (ih).

2. Circuit de régulation de courant selon la revendication 1, caractérisé en ce qu'une résistance (R) est disposée entre l'entrée inverseuse et l'entrée non inverseuse de l'amplificateur différentiel (dv;tv), qui réduit l'amplification de boucle du circuit de régulation de courant.

3. Circuit de régulation de courant selon la revendication 1 ou 2, caractérisé par les caractéristiques suivantes :
- l'étage de commutation d'impulsions (p) commute, pendant la pause entre impulsions, la pente ou l'amplification de courant de la seconde section de commande (s2) d'une première valeur à une seconde valeur, qui est supérieure à la première valeur pendant la durée des impulsions, et
- la source de courant (q), commandée par l'étage de commutation d'impulsions, alimente, pendant la pause entre impulsions, le second étage de commande avec un courant de référence de précharge (ir'), dont la valeur est inférieure au courant de référence (ir).

4. Circuit de régulation de courant selon la revendication 3, caractérisé en ce que la commutation de la pente ou de l'amplification de courant est réalisée au moyen du branchement en parallèle d'une section de commande auxiliaire (t2') avec la seconde section de commande (s2).

5. Circuit de régulation de courant selon l'une des revendications 1 à 4, caractérisé en ce qu'au moins une partie du circuit de régulation de courant est intégrée de façon monolithique selon la technique des transistors à effet de champ, notamment selon la technique CMOS.

6. Circuit de régulation de courant selon l'une des revendications 1 à 5, caractérisé en ce que la charge est une diode émettrice à infrarouge (d).

7. Circuit de régulation de courant selon l'une des revendications 1 à 6, caractérisé en ce que le dispositif de précharge (f) peut être désactivé par un signal de débranchement (of).

8. Circuit de régulation de courant selon l'une des revendications 5 à 7, caractérisé en ce que l'amplificateur différentiel (dv) est un amplificateur à transconductance (tv), dont la borne de sortie (k) est reliée à la borne de grille de premier et second transistors à effet de champ (t1, t2), notamment de premiers transistors à canal n, qui sont utilisés en tant que première et seconde sections de commande (s1,s2).
